## Europäisches Patentamt

## European Patent Office

## Office européen des brevets

(11) Veröffentlichungsnummer: **0 009 549**
**B2**

(12) **NEUE EUROPÄISCHE PATENTSCHRIFT**

(45) Veröffentlichungstag der neuen Patentschrift:
16.05.84

(21) Anmeldenummer: **79102420.1**

(22) Anmeldetag: **12.07.79**

(51) Int. Cl.³: **H 03 K 5/153**, H 04 L 1/00, H 04 B 15/00

(54) Schaltungsanordnung zum Entstören von Übertragungseinrichtungen für digitale Signale, insbesondere zum Ausblenden von höherfrequenten Störimpulsen beliebiger Polarität.

(30) Priorität: **21.09.78 DE 2841171**

(43) Veröffentlichungstag der Anmeldung:
**16.04.80 Patentblatt 80/8**

(45) Bekanntmachung des Hinweises auf die Patenterteilung:
**30.09.81 Patentblatt 81/39**

(45) Bekanntmachung des Hinweises auf die Entscheidung über den Einspruch:
**16.05.84 Patentblatt 84/20**

(84) Benannte Vertragsstaaten:
**AT BE CH FR IT NL**

(56) Entgegenhaltungen:
DE - A - 1 251 377
DE - A - 2 103 435
DE - A - 2 424 816
DE - A - 2 429 827
DE - A - 2 657 169
DE - A - 2 707 610
DE - B - 1 101 490
DE - B - 1 817 548
DE - B - 2 358 915
DE - B - 2 410 957
DE - B - 2 415 365
JP - B - 34 007 852

"Das TTL-Kochbuch", Juni 1975, Seiten 106, 107 Texas Instruments Deutschland GmbH

(73) Patentinhaber: **SIEMENS AKTIENGESELLSCHAFT,
Berlin und München Wittelsbacherplatz 2,
D-8000 München 2 (DE)**

(72) Erfinder: **Gottwald, Winfried, Kirchplatz 6b,
D-8033 Martinsried (DE)**

(56) Entgegenhaltungen: (Fortsetzung)
"Integrierte Digitalbausteine Kleines Praktikum" 3. Auflage, Februar 1974, Seiten 418, 419, Siemens AG

Schaltungsanordnung zum Entstören von Übertragungseinrichtungen für digitale Signale,
insbesondere zum Ausblenden von höherfrequenten Störimpulsen beliebiger Polarität

Die Erfindung bezieht sich auf eine Schaltungsanordnung zum Entstören von Übertragungseinrichtungen für digitale Signale und insbesondere auf eine Schaltungsanordnung zum Ausblenden von höherfrequenten Störimpulsen beliebiger Polarität, entsprechend dem Oberbegriff des Patentanspruchs.

Digitale Übertragungssysteme, die mit einer oder mehreren festgelegten Frequenzen arbeiten, wie z. B. digital arbeitende Magnetbandgeräte, unterliegen häufig Störungen, die durch das Schalten hoher Ströme, wie z. B. für die Antriebseinrichtungen des Magnetbandes in einem Magnetbandgerät, hervorgerufen sind. Zur Entstörung derartiger Übertragungssysteme sind eine Reihe von Lösungen bekanntgeworden. So ist es z. B. möglich, die Schaltungsanordnung und die Übertragungsleitungen sowohl bei der störenden Einrichtung als auch bei der gestörten Einrichtung zu schirmen. Der Nachteil dieser Lösung ist der hohe konstruktive Aufwand verbunden mit entsprechend hohen Kosten.

Weiter ist es möglich, in dem gestörten Übertragungsweg passive Filter einzusetzen. Ein Nachteil derart passiver Filter ist, daß sich für die positiven und negativen Flanken der mit dem Übertragungssystem zu übertragenden digitalen Signale in der Regel eine geringere und häufig unterschiedliche Flankensteilheit ergibt. Außerdem wirken sich unterschiedliche Schaltschwellen beim Empfänger der digitalen Signale im Hinblick auf die positiven und negativen Flanken nachteilig aus. Dadurch könnten unterschiedliche und damit störende Zeitverschiebungen der positiven und negativen Signalflanken auftreten. Um diese Nachteile zu vermeiden, wäre es möglich, ein sogenanntes getaktetes Übertragungssystem anzuwenden. Dieses stellt aber einen beachtlichen Mehraufwand dar und verursacht somit wesentlich höhere Kosten.

Ebenfalls möglich wäre die Übertragung eines sogenannten Differenzsignales, wozu aber zwei Leitungen pro Kanal erforderlich sind, was wiederum Mehraufwand und Kosten bedeutet.

Aus der japanischen Patentanmeldung 34-7 852 ist eine Schaltungsanordnung zum Entstören von Übertragungseinrichtungen für digitale Signale, insbesondere zum Ausblenden von höherfrequenten Störimpulsen beliebiger Polarität bekannt. Diese bekannte Schaltungsanordnung enthält zwei monostabile Kippschaltungen, die aus jeder positiven und negativen Flanke des Eingangssignals einen Impuls fester Breite und gleicher Polarität erzeugen. Zu diesem Zweck werden den monostabilen Kippschaltungen in einem Impulsformer erzeugte invertierte und nichtinvertierte Eingangssignale zugeführt. Den monostabilen Kippschaltungen sind sogenannte Zusammensetzungskreise nachgeschaltet, die die Impulse fester Breite mit den Ausgangssignalen der Impulsformerschaltungen verknüpfen. Die Ausgangssignale der Zusammensetzungskreise werden differenziert, um Setz- bzw. Rücksetzsignale für ein Flipflop zu erzeugen, an dessen Ausgang die entstörten digitalen Signale abgegeben werden. Diese Schaltungsanordnung erfordert einen verhältnismäßig großen Aufwand, da für beide Polaritäten der Eingangssignale eigene Signalwege erforderlich sind.

Die DE-AS 12 51 377 offenbart eine Schaltungsanordnung zum Beseitigen von Prell- und Störimpulsen. Diese bekannte Schaltungsanordnung beseitigt die Prell- bzw. die Störimpulse nur dann, wenn sie unmittelbar nach einem Polaritätswechsel der digitalen Signale auftreten. Für eine allgemeine Befreiung von Störimpulsen von digitalen Signalen ist diese Schaltungsanordnung nicht vorgesehen und auch nicht geeignet.

Aus der DE-AS 24 10 957 ist eine Schaltungsanordnung zum Entstören von digitalen Signalen bekannt, die eine monostabile Kippschaltung und eine Vielzahl von Verknüpfungsgliedern, sowie ein Flipflop enthält. Diese Schaltungsanordnung erfordert einen verhältnismäßig großen Aufwand, da einerseits eine monostabile Kippstufe mit zwei Eingängen erforderlich ist, da die Vielzahl von Verknüpfungsgliedern erforderlich ist und da zusätzlich eines der Verknüpfungsglieder mit einem eine Verzögerungszeit bestimmenden Kondensator versehen ist.

Der vorliegenden Erfindung lag daher die Aufgabe zugrunde, eine Schaltungsanordnung zum Entstören von Übertragungseinrichtungen für digitale Signale und insbesondere zum Ausblenden von höherfrequenten Störimpulsen beliebiger Polarität zu schaffen, die die Flankensteilheit der positiven und negativen Flanken der zu übertragenden digitalen Signale nicht verändert und außerdem für das ganze Übertragungssystem nur einen vernachlässigbar geringen Mehraufwand darstellt. Erfindungsgemäß wird diese Aufgabe durch die im kennzeichnenden Teil des Patentanspruchs angegebenen Merkmale gelöst.

Durch die Verwendung rein digitaler Schaltkreise tritt praktisch keinerlei Veränderung der Flankensteilheit des zu übertragenden digitalen Signals auf und da die gesamte Schaltung nur aus zwei monostabilen, einer bistabilen Kippschaltung und einem ODER-Gatter besteht, die in Form preiswerter integrierter Bausteine zur Verfügung stehen, ist der Aufwand für die erfindungsgemäße Schaltungsanordnung außerordentlich gering.

Ein Ausführungsbeispiel der Erfindung ergibt sich aus der nachfolgenden Beschreibung der in

Fig. 1 dargestellten Schaltungsanordnung in Verbindung mit dem in

Fig. 2 gezeigten Impulsdiagramm.

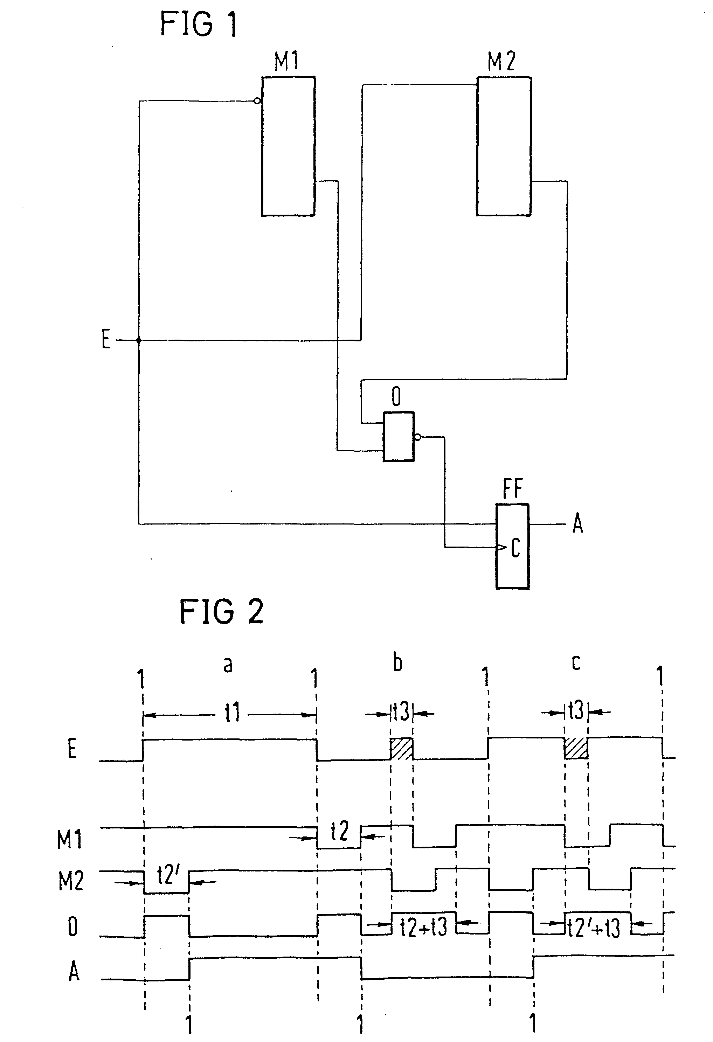

Die in Fig. 1 dargestellte Schaltungsanordnung besteht aus zwei monostabilen Kippschaltungen M1 und M2, einem ODER-Gatter O und einem Flip-Flop FF. Das zu übertragende Eingangssignal, z. B. ein digitales Schreib-Datensignal im Fall eines Magnetbandgerätes, wird der Eingangsklemme E zugeführt. Fig. 2 zeigt in Zeile E im Abschnitt a die Form eines solchen Signals. Um erfindungsgemäß aus jeder positiven und negativen Flanke des Eingangssignals einen Impuls fester Breite und gleicher Polarität abzuleiten, ist die monostabile Kippschaltung M1 mit ihrem invertierenden Eingang und die monostabile Kippstufe M2 mit ihrem nichtinvertierenden Eingang mit dieser Eingangsklemme E verbunden. Fig. 2 zeigt in den Zeilen M1 und M2, daß sowohl aus der positiven als auch aus der negativen Flanke des Eingangssignals ein Impuls mit der Breite t2 bzw. t2' gebildet wird. Beide Impulse haben gleiche Polarität. Diese Ausgangssignale der beiden Kippstufen M1 und M2 werden den beiden Eingängen der ODER-Schaltung zugeführt, die die beiden Impulse verknüpft. Das Ausgangssignal der ODER-Schaltung O wird dann erfindungsgemäß dem Takteingang C des Flip-Flops FF zugeführt. Der andere Eingang des Flip-Flops FF ist mit der Eingangsklemme E verbunden. Auf diese Weise wird dieser Eingang jeweils durch das an der Eingangsklemme liegende Eingangssignal vorbereitet. Verwendet man für das Flip-Flop FF ein bekanntes D-Flip-Flop oder ein J-K-Flip-Flop, dann kippt dieses nur dann in die jeweils andere Lage, wenn sich die Information an dem D- bzw. J-K-Eingang zum Zeitpunkt des Auftretens der Rückflanke des am Takteingang C anliegenden Taktimpuls gegenüber dem Zeitpunkt vor dem Taktimpuls geändert hat.

Betrachtet man den Fall a von Fig. 2 so zeigt sich, daß aus der ersten, in diesem Fall positiven Flanke des Eingangssignals mit Hilfe der monostabilen Kippschaltung M2 ein Impuls mit der Dauer t2' abgeleitet und dem ODER-Gatter O zugeführt wurde. Das invertierte Ausgangssignal des ODER-Gatters bildet das Taktsignal für das Flip-Flop FF. Da zum Zeitpunkt der Rückflanke diese am Ausgang des ODER-Gatters O erscheinenden Impulses sich die Information der Eingangsklemme E gegenüber dem Zeitpunkt vor dem Taktimpuls geändert hatte, wird das Flip-Flop FF gekippt und am Ausgang A der Schaltungsanordnung erscheint eine positive Flanke, was in Fig. 2 in Zeile A gezeigt ist.

Nach Ablauf der Zeit t1 soll im Eingangssignal an der Klemme E eine negative Flanke auftreten. Diese führt mit Hilfe der monostabilen Kippstufe M1 zu einem Impuls mit der Dauer t2, der wiederum dem ODER-Gatter O und von diesem dem Takteingang C des Flip-Flops FF zugeführt wird. Wenn bis zum Zeitpunkt der Rückflanke des an dem Ausgang des ODER-Gatters O auftretenden Impulses sich die Information des an der Klemme E liegenden Eingangssignals wieder geändert hat, führt dies zu einem erneuten Kippen des Flip-Flops FF und der Bildung einer negativen Flanke des an der Klemme A erscheinenden Ausgangssignals. Das Signal an der Ausgangsklemme A entspricht somit genau dem an der Klemme E anliegenden Eingangssignals mit einer Verzögerungszeit, die gleich ist der Breite

der Taktimpulse t2 bzw. t2'.

Da die Taktimpulse von zwei monostabilen Kippstufen erzeugt werden, kann es bei unterschiedlicher Breite der von diesen beiden monostabilen Kippstufen erzeugten Taktimpulse zu unterschiedlichen Verschiebungen der positiven und negativen Flanken des Ausgangssignals an der Klemme A kommen. Derartige Verschiebungen sind unerwünscht, da sie z. B. bei der Aufzeichnung von Daten auf einem Magnetband zu Verzerrungen führen. Derartige Verschiebungen der positiven und negativen Flanken des Ausgangssignals lassen sich aber ohne weiteres dadurch vermeiden, daß für die monostabile Kippstufen integrierte Schaltungen verwendet werden, die zwei auf einem gemeinsamen monolithischen Substrat angeordnete und somit exakt gleich arbeitende monostabile Kippschaltungen enthalten.

Wie Fig. 2 im Falle b und c zeigt, können zwischen den positiven und negativen Flanken des Nutzsignales Störimpulse in beiden Polaritäten auftreten. Die Schaltungsanordnung gemäß der Erfindung ist in der Lage, derartige Störimpulse unwirksam zu machen. Im Fall b von Fig. 2 enthält das an der Klemme E liegende Eingangssignal in der Mitte zwischen zwei informationstragenden Signalflanken vom Abstand t1 einen positiven Störimpuls der Breite t3. Die positive Flanke dieses Störimpulses löst die monostabile Kippschaltung M2, die negative Flanke des Störimpulses die monostabile Kippstufe M1 aus. Da die Ausgangssignale dieser beiden monostabilen Kippschaltungen der ODER-Schaltung O zugeführt und von dieser verknüpft werden, ergibt sich am Ausgang der ODER-Schaltung O ein Taktimpuls von der Breite t2 + t3. Da zum Zeitpunkt der Rückflanke dieses Taktimpulses mit der Dauer t2 + t3 die Information an dem Vorbereitungseingang des Flip-Flops FF die gleiche ist wie vor dem Auftreten des Taktimpulses, kippt das Flip-Flop FF nicht und die Information am Ausgang A bleibt somit unverändert; d. h. der Störimpuls ist ausgeblendet worden.

Fig. 2 zeigt schließlich im Abschnitt c ein Beispiel für das Auftreten eines negativen Störimpulses in dem Eingangssignal an der Klemme E, die Bildung eines Taktimpulses ebenfalls von der Breite t2' + t3 und die Ausblendung des Störimpulses im Ausgangssignal an der Klemme A.

Liste der Bezugszeichen

E Eingang
M1 monostabile Kippstufe
M2 monostabile Kippstufe
O ODER-Gatter
ff Flip-Flop
C Takteinang
A Ausgang
t1 Abstand der Flanken des Eingangssignals
t2, t2' Breite der Taktimpulse
t3 Breite der Störimpulse

## Patentanspruch

Schaltungsanordnung zum Entstören von Übertragungseinrichtungen für digitale Signale, insbesondere zum Ausblenden von höherfrequenten Störimpulsen beliebiger Polarität, unter Verwendung zweier monostabiler Kippschaltungen, die aus jeder positiven und negativen Flanke des Eingangssignals einen Impuls fester Breite und gleicher Polarität erzeugen, dadurch gekennzeichnet, daß die Impulse mit Hilfe einer ODER-Schaltung (O) verknüpft werden und daß das Ausgangssignal der ODER-Schaltung (O) als Taktsignal dem Takteingang (C) eines Flipflops (FF) zugeführt wird, dessen anderer Eingang von dem Eingangssignal (E) vorbereitet wird, derart, daß das Flipflop (FF) nur dann von der Rückflanke der Taktimpulses in die jeweils andere Lage gekippt wird, wenn sich das Eingangssignal (E) an dem Vorbereitungseingang des Flipflops (FF) zu diesem Zeitpunkt gegenüber dem Zeitpunkt vor dem Taktimpuls geändert hat.

## Claim

A circuit arrangement for interference-clearing of transmission devices for digital signals, in particular for gating out higher-frequency interference pulses of arbitrary polarity, employing two monostable trigger circuits which produce a pulse of fixed width and constant polarity from each positive and negative flank of the input signal, characterised in that the pulses are linked with the aid of an OR-circuit (O) and that the output signal of the OR-circuit (O) is fed as a clock pulse signal to the clock pulse input (C) of a flip-flop (FF), whose other input is prepared by the input signal (E) in such a manner that the flip-flop (FF) is triggered by the trailing flank of the clock pulses into the respective other position only if the input Signal (E) at the preparation input of the flip-flop (FF) has changed at this time compared with the time before the clock pulse.

## Revendication

Montage pur déparasiter des installations de transmission pour des signaux numériques, plus particulièrement pur séparer des impulsions parasites de haute fréquence et de polarité quelconque, avec mise en oeuvre de deux multivibrateurs monostables qui produisent à partir de chaque flanc positif ou négativ du signal d'entrée une impulsion de largeur fixe et de même polarité, caractérisé par le fait que les impulsions sont combinées logiquement à l'aide d'un circuit OU (O) et que le signal de sortie dudit circuit OU (O) est appliqué, en tant que signal de cadence, à l'entrée de cadence (C) d'un multivibrateur bistable (FF) dont l'autre entrée est préparée par le signal d'entrée (E) de manière que le multivibrateur bistabile (FF) n'est basculé dans son autre position, par le flanc postérieur des impulsions de cadence, que si le signal d'entrée au niveau de l'entrée de préparation du multivibrateur bistable (FF) s'est modifié à cet instant par rapport à l'instant avant l'impulsion de cadence.

## FIG 1

## FIG 2